(19) Europäisches Patentamt / European Patent Office / Office européen des brevets

(11) **EP 4 501 582 A1**

(12) **EUROPEAN PATENT APPLICATION**
published in accordance with Art. 153(4) EPC

(43) Date of publication:
05.02.2025 Bulletin 2025/06

(21) Application number: 22935625.8

(22) Date of filing: 27.10.2022

(51) International Patent Classification (IPC):
*B29C 48/395* (2019.01)     *B29C 48/505* (2019.01)
*B29C 48/68* (2019.01)      *B29C 48/92* (2019.01)

(52) Cooperative Patent Classification (CPC):
B29C 48/395; B29C 48/505; B29C 48/68;
B29C 48/92

(86) International application number:
PCT/JP2022/040054

(87) International publication number:
WO 2023/188494 (05.10.2023 Gazette 2023/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 31.03.2022 JP 2022060712

(71) Applicant: The Japan Steel Works, Ltd.
Tokyo 141-0032 (JP)

(72) Inventors:
• FUKUZAWA, Yohei
  Tokyo 141-0032 (JP)
• ODA, Tomoya
  Tokyo 141-0032 (JP)
• NAKAGAWA, Kazuma
  Tokyo 141-0032 (JP)

(74) Representative: Simmons & Simmons LLP
(Munich)
Lehel Carré
Gewürzmühlstraße 11
80538 Munich (DE)

(54) **SIMULATION DEVICE, SIMULATION METHOD, AND SIMULATION PROGRAM**

(57) This simulation device simulates the behavior of an extruder, the simulation device comprising: an acquisition unit for acquiring data relating to the behavior of an extruder from a control device for controlling operation of the extruder, a sensor provided to the extruder, or an imaging device for capturing images of components constituting the extruder; and a calculation unit for calculating physical quantities indicating the behavior of the extruder on the basis of the acquired data.

FIG.9

EP 4 501 582 A1

## Description

Technical Field

The present invention relates to a simulation device, a simulation method and a simulation program that calculate a predetermined physical quantity in an extruder.

Background Art

A simulation device has been presented that estimates the internal pressure at areas in the axial direction of an extruder, the filling rate of resin as a raw material, the temperature and the like (e.g., Patent Literature 1). The simulation device calculates a filling rate, a pressure, a temperature and the like inside the extruder based on data indicating physical properties of resins, extrusion conditions and a screw construction. The simulation device outputs an estimation result indicating the calculated filling rate, pressure, temperature and the like. The output estimation result is utilized for optimizing and evaluating the process conditions.

Citation List

Patent Literature:

Patent Literature 1: Japanese Patent Application Laid-Open Publication No. 2004-148722

Summary of Invention

Technical Problems

Meanwhile, in the conventional simulation device, the analysis conditions such as the physical properties of resins, extrusion conditions and screw construction have been required to be set manually.
An object of the present disclosure is to provide a simulation device, a simulation method and a simulation program that are capable of automatically setting analysis conditions necessary for simulation and reducing the trouble of manually inputting the analysis conditions.

Solution to Problems

A simulation device according to one aspect of the present disclosure is a simulation device simulating a behavior of an industrial machine, comprising: an acquisition unit that acquires data related to a behavior of the industrial machine from a control device performing operation control of the industrial machine, a sensor provided on the industrial machine or an imaging device imaging a component constituting the industrial machine; and an arithmetic unit that calculates a physical property indicating a behavior of the industrial machine on the basis of acquired data.
A simulation method according to one aspect of the present disclosure is a simulation method simulating a behavior of an industrial machine, comprising: acquiring data related to a behavior of the industrial machine from a control device performing operation control of the industrial machine, a sensor provided on the industrial machine or an imaging device imaging a component constituting the industrial machine; and calculating a physical property indicating a behavior of the industrial machine on the basis of acquired data.
A simulation program according to one aspect of the present disclosure is a simulation program causing a computer to simulate a behavior of an industrial machine, the program causing the computer to execute the processing of: acquiring data related to a behavior of the industrial machine from a control device performing operation control of the industrial machine, a sensor provided on the industrial machine or an imaging device imaging a component constituting the industrial machine; and calculating a physical property indicating a behavior of the industrial machine on the basis of acquired data.

Advantageous Effects of Invention

The present disclosure can automatically set analysis conditions necessary for simulation and reduce the trouble of manually inputting the analysis conditions. Brief Description of Drawings
FIG. 1 is a schematic view illustrating an example of the configuration of an extruder system according to Embodiment 1.

FIG. 2 is a schematic view illustrating an example of the configuration of an extruder according to Embodiment 1.

FIG. 3 is a block diagram illustrating an example of the configuration of a control device according to Embodiment 1.

FIG. 4 is a block diagram illustrating an example of the configuration of a simulation device according to Embodiment 1.

FIG. 5A is a block diagram illustrating an example of the configuration of a learning model according to Embodiment 1.

FIG. 5B is a block diagram illustrating an example of the configuration of a learning model according to Embodiment 1.

FIG. 6 is a flowchart depicting a simulation method according to Embodiment 1.

FIG. 7 is a flowchart depicting the simulation method according to Embodiment 1.

FIG. 8 is a schematic view illustrating a display example of a simulation result according to Embodiment 1.

FIG. 9 is a flowchart depicting a processing procedure of a control device according to Embodiment 2.

FIG. 10 is a schematic view illustrating a display example of a simulation result according to Embodiment 2.

Description of Embodiments

Specific examples of a simulation device, a simulation method and a simulation program according to embodiments of the present invention will be described below with reference to the drawings. It should be noted that the present invention is not limited to these examples, and is indicated by the scope of claims, and is intended to include all modifications within the meaning and scope equivalent to the scope of claims. Furthermore, at least parts of the following embodiment and modifications may arbitrarily be combined.

Hereinafter, the present invention will specifically be described with reference to the drawings illustrating the embodiments thereof.

Embodiment 1

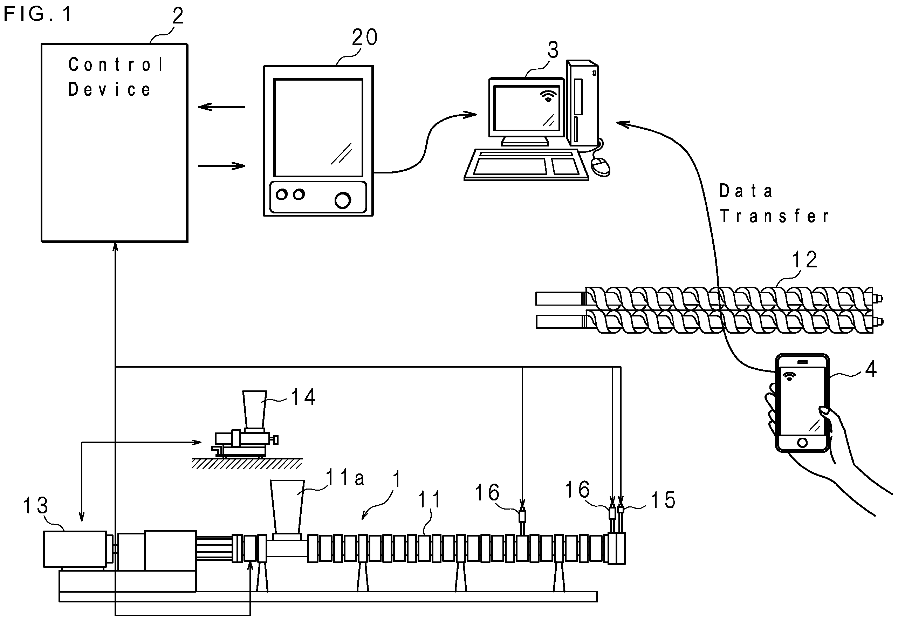

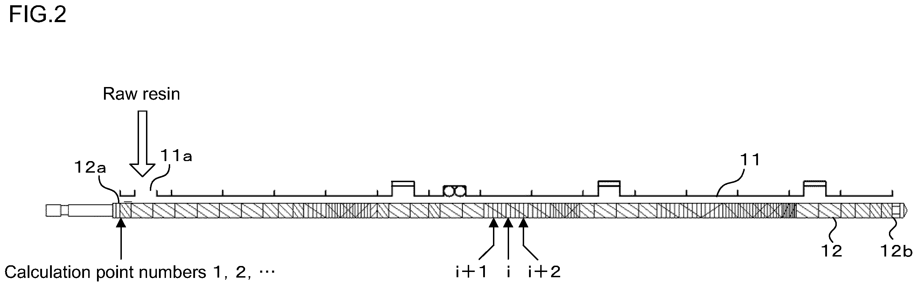

FIG. 1 is a schematic view illustrating an example of the configuration of an extruder system according to Embodiment 1. FIG. 2 is a schematic view illustrating an example of the configuration of the extruder 1 according to Embodiment 1. The extruder system is provided with an extruder 1, a control device 2, a simulation device 3 according to Embodiment 1 and an imaging device 4.

<Extruder 1>

The extruder 1 includes a cylinder 11 with a heater, a screw 12 that is provided so as to be drivable in the rotary direction within the cylinder 11 and that melts/plasticizes and kneads a raw material and a rotary motor 13 that rotates the screw 12.

The cylinder 11 is configured to be a bar of cylinder 11 by combining multiple cylinder parts integrated together. The cylinder part more toward the root (left side in FIG. 1) is provided with a hopper 11a into which raw materials are injected.

The number of hoppers 11a is not limited to a particular value. Multiple hoppers 11a for injecting multiple types of raw resins may be disposed in the cylinder 11. In addition, a vacuum vent may also be disposed in the cylinder 11 as necessary.

The screw 12 is configured to be a bar of screw 12 by combining multiple types of screw pieces integrated together. For example, a flight screw-shaped forward flight piece that carries a raw material in a forward direction, a reverse flight piece that carries a raw material in a reverse direction, a kneading piece that kneads the raw material and the like are combined in an order and at positions according to the characteristics of the raw material, to form the screw 12.

The extruder 1 is provided with a feeder 14 for supplying a raw resin to the cylinder 11. The feeder 14 feeds a preset extrusion output of the raw resin to the hopper 11a.

The extruder 1 is provided with a sensor for measuring data required to simulate the behavior of the extruder 1. More specifically, the cylinder 11 is provided with a temperature sensor 15 for detecting the temperature of the cylinder 11 and the temperature of the resin inside the cylinder 11 and multiple pressure sensors 16 for detecting the pressures inside the cylinder 11 and the pressure of the resin inside the cylinder 11. The temperature sensor 15, which is provided at the tip of the cylinder 11, for example, detects the temperature of the cylinder 11 or the raw resin, at the tip. The temperature sensor 15 outputs a signal indicating the detected temperature to the control device 2. A first pressure sensor 16, which is located at the tip of the cylinder 11, detects the pressure inside the cylinder 11 or the pressure of the raw resin, at the tip. A second pressure sensor 16, which is located more toward the root of the cylinder 11 rather than the tip of the cylinder 11, detects the pressure inside the cylinder 11 or the pressure of the raw resin, at the location. The first and second pressure sensors 16 output signals indicating the detected pressures to the control device 2.

<Control Device 2>

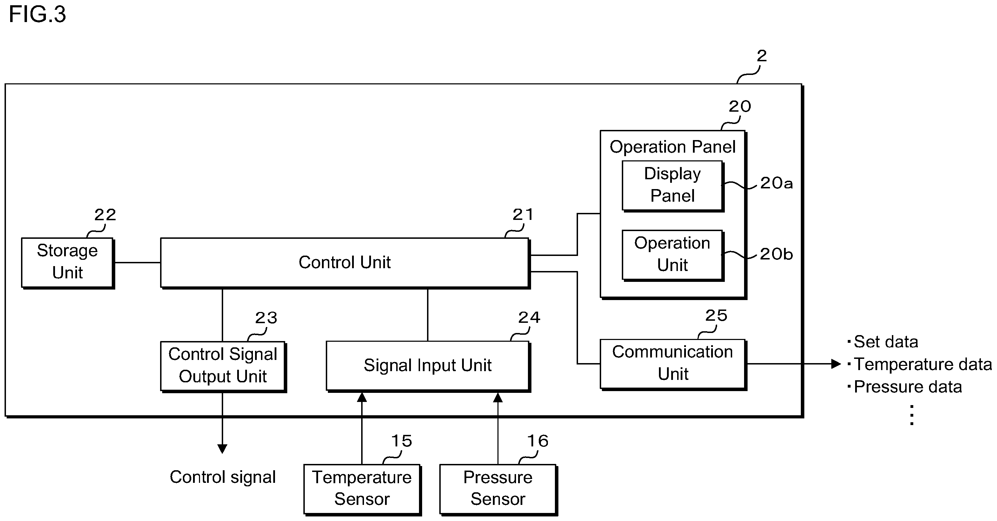

FIG. 3 is a block diagram illustrating an example of the configuration of the control device 2 according to Embodiment 1. The control device 2 is a computer that performs operation control of the extruder 1 and is provided with a control unit 21, a storage unit 22, a control signal output unit 23, a signal input unit 24, a communication unit 25 and an operation panel 20.

The operation panel 20 is an interface for setting the operating conditions or the like of the extruder 1 and operating the action of the extruder 1. The operation panel 20 is provided with a display panel 20a and a operation unit 20b. The display panel 20a, which is a display device such as a liquid crystal display panel, an organic EL display panel or the like, displays an acceptance screen to accept the settings of the operating conditions of the extruder 1 according to the control by the control unit 21 and displays the status of the extruder 1. The operation unit 20b, which is an input device for inputting the operating conditions of the extruder 1, includes an operation button, a touch panel and the like. The operation unit 20b provides the control unit 21 with data indicating the accepted operating conditions. The operating conditions include, for example, an extruder size, an extrusion output, a screw rotational speed and a cylinder temperature. The extruder size corresponds to the full length of the screw 12.

The control unit 11 has an arithmetic circuit such as a CPU (Central Processing Unit), an MPU (Micro-Processing Unit), an Application Specific Integrated Circuit (ASIC), a Field-Programmable Gate Array (FPGA) or the like, an internal storage device such as a ROM (Read Only Memory), a RAM (Random Access Memory), an I/O terminal or the like. The control unit 21 reads and executes an operation control program stored in the storage unit 22 to perform operation control of the extruder 1. In addition, the control unit 21 executes the processing of collecting data related to the behavior of the extruder 1 and sending the data to the simulation device 3.

The control signal output unit 23 outputs to the extruder 1 a control signal for controlling the operation of the extruder 1 according to the control by the control unit 21. Specifically, the control signal output unit 23 outputs to the extruder 1 a control signal indicating starting of rotation, a rotation speed, stopping of rotation and the like of the rotary motor 13. In addition, the control signal output unit 23 outputs to the extruder 1 a control signal indicating the heating temperature of the cylinder 11 and a control signal indicating control of the supply of resins by the feeder 14.

The signal input unit 24, which is connected to the temperature sensor 15 and the pressure sensor 16, receives signal inputs that are output from the temperature sensor 15 and the pressure sensor 16. The signal input unit 24 provides data indicating the temperature and pressure inside the cylinder 11 to the control unit 21.

The communication unit 25 is a communication circuit that sends and receives data to/from the simulation device 3. The communication unit 25 sends data related to the behavior of the extruder 1 to the simulation device 3 according to the control by the control unit 21. Specifically, the communication unit 25 sends to the simulation device 3 set data indicating the operating conditions set to the control device 2 and measurement data including temperature data indicating the temperature of the cylinder 11 and pressure data indicating the pressure of the cylinder 11.

<Simulation Device 3>

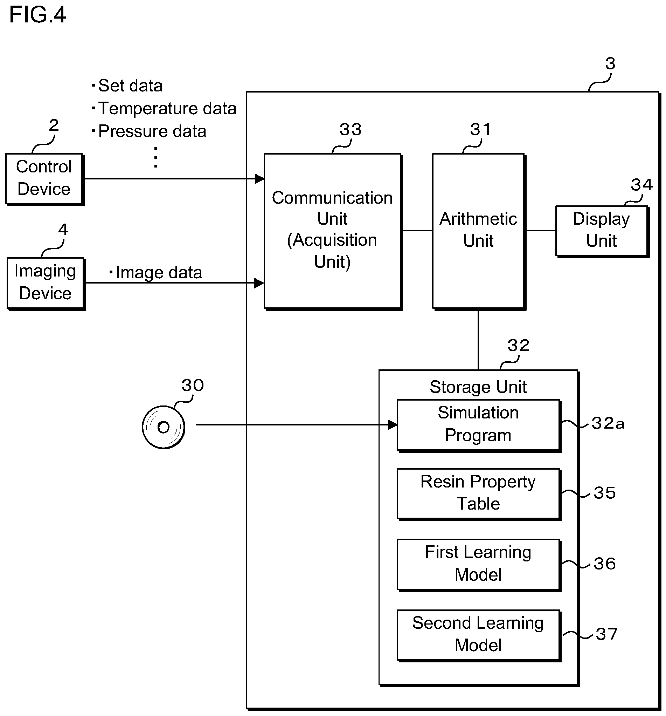

FIG. 4 is a block diagram illustrating an example of the configuration of the simulation device 3 according to Embodiment 1. The simulation device 3 according to the present embodiment, which is a computer that simulates the behavior of the extruder 1, is provided with an arithmetic unit 31, a storage unit 32, a communication unit 33 and a display unit 34.

The arithmetic unit 31 has an arithmetic circuit such as a CPU (Central Processing Unit), an MPU (Micro-Processing Unit), an Application Specific Integrated Circuit (ASIC), a Field-Programmable Gate Array (FPGA) or the like and an internal storage device such as a ROM (Read Only Memory), a RAM (Random Access Memory) and an I/O terminal or the like. The arithmetic unit 31 reads and executes a simulation program (program product) 32a stored in the storage unit 32 to perform processing of calculating predetermined physical properties in the twinscrew extruder 1. Note that each functional part of the simulation device 3 may be realized in software, or some or all of the functional parts thereof may be realized in hardware.

The storage unit 32 is a storage device such as a hard disk, an EEPROM (Electrically Erasable Programmable ROM), a flash memory or the like. The storage unit 32 stores various programs to be executed by the arithmetic unit 31 and various data necessary for the processing to be executed by the arithmetic unit 31. In the present embodiment, the storage unit 32 stores a simulation program 32a to be executed by at least the arithmetic unit 31. The storage unit 32 further stores a resin property table 35 in which viscosities of multiple raw resins are each associated with other properties of the raw resins, for example, the density, the thermal conductivity and the specific heat when the raw resin is a solid, the density, the thermal conductivity and the specific heat when the raw resin is a melt, the molten heat amount and the melting point. The details of the learning model are described later.

An image obtained by taking an image of the screw 12 and data of the image are referred to as screw image data. Likewise, a cylinder image obtained by taking an image of the cylinder 11 and data of the image are referred to as cylinder image data.

The simulation program 32a may be written to the storage unit 32 at the manufacturing stage of the simulation device 3. The simulation program 32a may be delivered from another information processing apparatus over the network. The simulation device 3 obtains the simulation program 32a through communication and writes it to the storage unit 32. The simulation program 32a may be readably recorded in a recording medium 30 including a semiconductor memory such as a flash memory, an optical disk, a magneto-optical disk and a magnetic disk. The simulation device 3 reads the simulation program 32a and stores it in the storage unit 32.

The communication unit 33 is a communication circuit that transmits and receives data to/from the control device 2. The communication unit 33 receives set data and measurement data such as temperature data and pressure data, which are sent from the control device 2. The set data, temperature data and pressure data that are received by the communication unit 33 are stored in the storage unit 32.

In addition, the communication unit 33 sends and receives data to/from the imaging device 4. The imaging device 4 is a device with a camera having a communication function, for example, a smartphone. The imaging device 4 according to Embodiment 1 is used for taking an image of the cylinder 11 and the screw 12 that constitute the extruder 1. The imaging device 4 sends cylinder image data obtained by taking an image of the cylinder 11 and screw image data obtained by taking an image of the screw 12 to the simulation device 3. The communication unit 33 receives the cylinder image data and the screw image data that are sent from the imaging device 4. The cylinder image data and screw image data that are received by the communication unit 33 are stored in the storage unit 32.

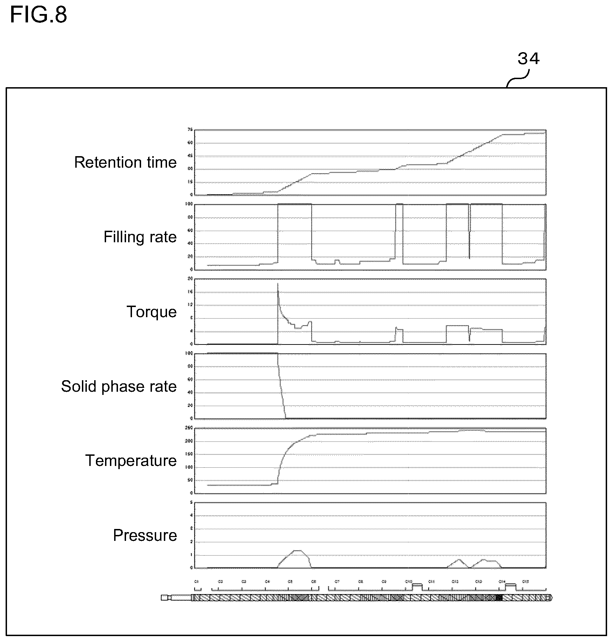

The display unit 34 is a display device such as a liquid crystal display panel, an organic EL display panel or the like. The display unit 34 displays predetermined physical quantities representing the behavior of the extruder 1 based on the analysis result data output from the arithmetic unit 31. The predetermined physical quantities include the retention time, filling rate, torque, solid phase ratio (filling factor of the solid phase) of the raw resin, the temperature or pressure of the raw resin and the like. The display unit 34 displays the distributions of the above-mentioned physical quantities along the axial direction of the extruder (see FIG. 8).

The aforementioned simulation device 3 may be a multi-computer configured by including multiple computers, and may be a virtual machine virtually constructed by software. In addition, the simulation device 3 may be constructed as a cloud server.

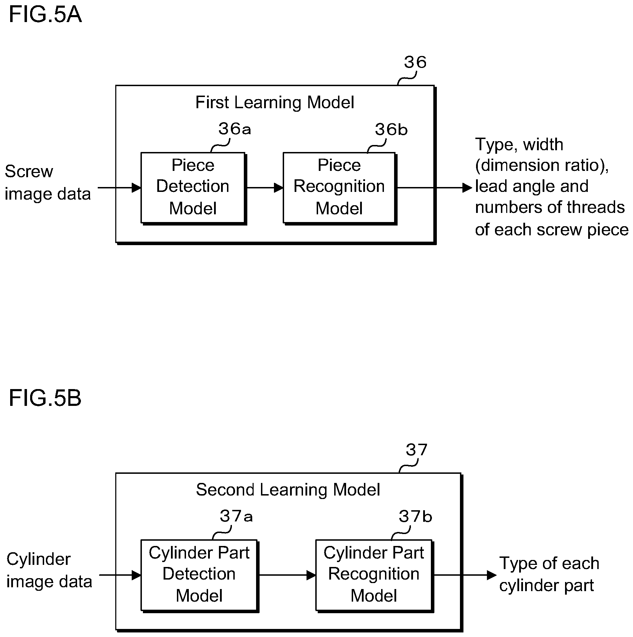

FIG. 5A and FIG. 5B are each a block diagram illustrating an example of the configurations of a learning model according to Embodiment 1. FIG. 5A conceptually illustrates the configuration of a first learning model 36, while FIG. 5B conceptually illustrates the configuration of a second learning model 37.

The first learning model 36 includes, for example, a piece detection model 36a and a piece recognition model 36b. The piece detection model 36a is a trained machine learning model that, if screw image data is input, outputs information indicating the positions and ranges of the images of the screw pieces constituting the screw 12 included in the screw image. The piece detection model 36a is a convolutional neural network (CNN), for example. The learning model includes an input layer for inputting a screw image, an intermediate layer for extracting features of the image and an output layer for outputting information indicating the positions and ranges of the screw pieces contained in the screw image. The intermediate layer is configured by alternately connecting convolutional layers for convolving pixel values of the pixels of the image input to the input layer and pooling layers for mapping the pixel values convolved in the convolutional layer, the intermediate layer extracting the features of the image while compressing the pixel information of the screw image.

The piece recognition model 36b is a trained machine learning model that outputs, if the image data of each screw piece detected by the piece detection model 36a is input, information on the type, width, lead angle and the number of thread of the screw piece. The aforementioned width of the screw piece is a dimensionless quantity and is represented by a ratio of the diameter of the screw piece and the length in the axial direction, for example. The piece recognition model 36b may also be configured using CNN.

Though an example where the first learning model 36 is configured using the piece detection model 36a as an object detection model and the piece recognition model 36b as an image recognition model was described, the first model may be configured using R-CNN, Fast R-CNN, Faster R-CNN, YOLO (You OnlyLook Once) or the like. The first learning model 36 can output, if a screw image is input, information including the position and range of each screw piece image and the type of the screw piece.

The second learning model 37 includes, for example, a cylinder part detection model 37a and a cylinder part recognition model 37b. The cylinder part detection model 37a is a trained machine learning model that outputs, if cylinder image data is input, information indicating the position and range of the image of each of the multiple cylinder parts constituting the cylinder 11 contained in the cylinder image. The configuration of the cylinder part detection model 37a is similar to that of the piece detection model 36a. Note that the cylinder part detection model 37a has been trained to detect cylinder parts using cylinder images as training data.

The cylinder part recognition model 37b is a trained machine learning model that outputs, if image data of each of the cylinder parts detected by the cylinder part detection model 37a is input, the type of the cylinder part. The cylinder part recognition model 37b may also be configured with CNN.

Note that the second learning model 37 may be configured using R-CNN, Fast R-CNN, Faster R-CNN, YOLO or the like. The second learning model 37 can output, if the cylinder image is input, information on the positions and ranges of the images of the cylinder parts and the types of the cylinder parts.

<Simulation Method>

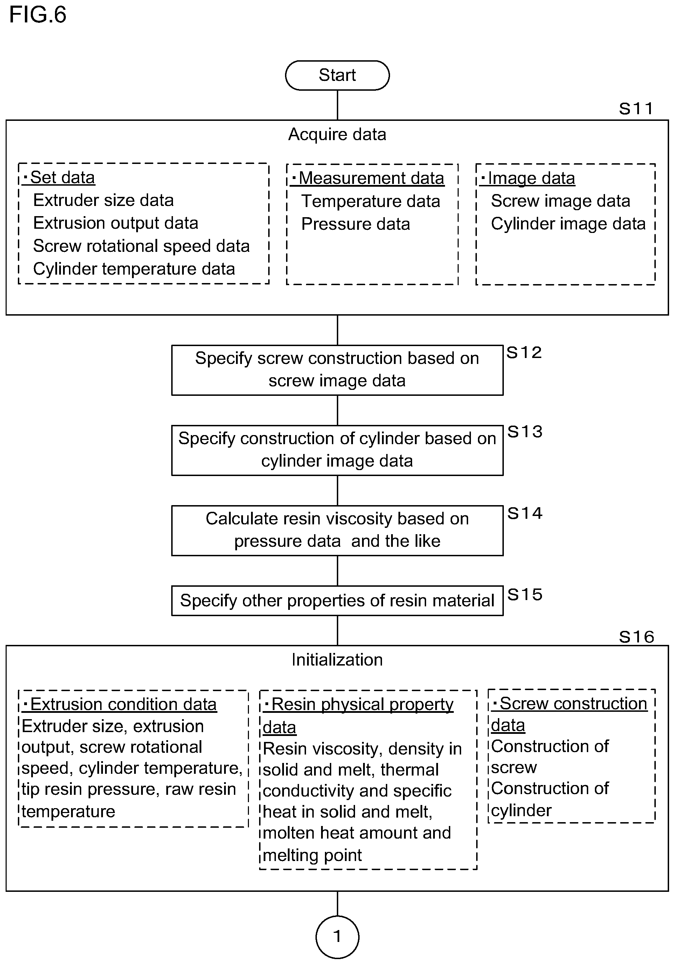

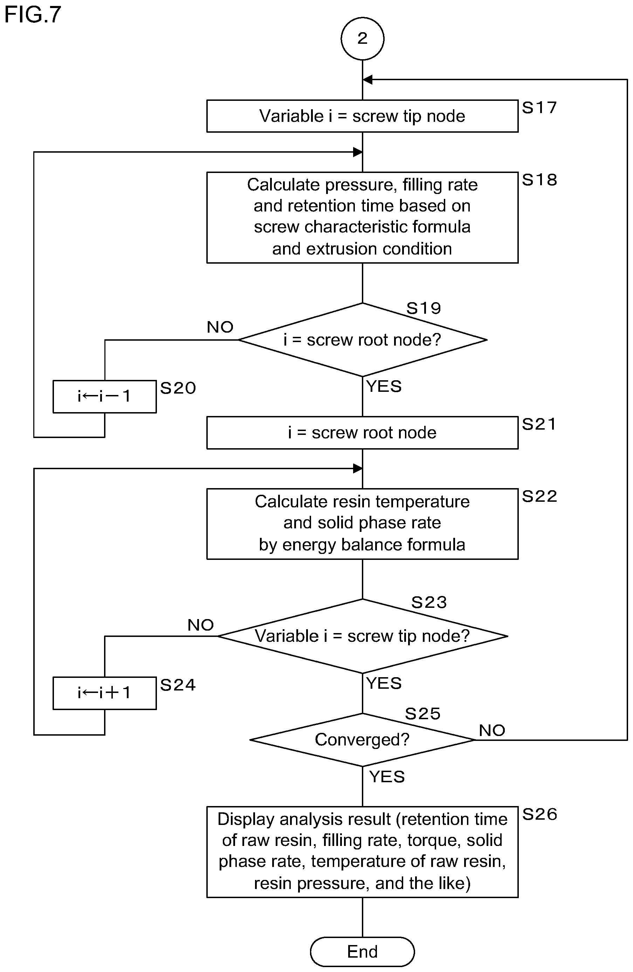

FIGs. 6 and 7 illustrate each a flowchart depicting a simulation method according to Embodiment 1. The arithmetic unit 31 of the simulation device 3 acquires data related to the behavior of the extruder 1 from the control device 2 and the imaging device 4 (step S11). Specifically, the arithmetic unit 31 acquires, via the communication unit 33, set data such as extruder size data, extrusion output data, screw rotational speed data, cylinder temperature data and the like from the control device 2. Moreover, the arithmetic unit 31 acquires measurement data such as temperature data, pressure data and the like from the control device 2. Note that the arithmetic unit 31 may be configured to directly acquire temperature data and pressure data from the temperature sensor 15 and the pressure sensor 16, respectively. In addition, the arithmetic unit 31 acquires image data such as screw image data, cylinder image data and the like from the imaging device 4.

Next, the arithmetic unit 31 specifies a screw construction based on the acquired screw image data (step S12). Specifically, the arithmetic unit 31 inputs the screw image data to the first learning model 36 to specify the types, widths (dimension ratios), lead angles and the numbers of threads and the like of the multiple screw pieces constituting the screw 12. The information on the screw construction can determine coefficients included in a screw characteristic formula described later, e.g., screw characteristic parameters. For example, the storage unit 32 stores the correspondences between the screw construction data and the screw characteristic parameters. The arithmetic unit 31 determines a screw characteristic parameter by referring to the correspondences. The correspondence specifically includes a table, a function or the like.

The arithmetic unit 31 specifies a construction of the cylinder 11 based on the acquired cylinder image data (step S13). Specifically, the arithmetic unit 31 inputs the cylinder image data to the second learning model 37 to specify the types of the multiple cylinder parts that constitute the cylinder 11. The information on the construction of the cylinder 11 can be used to specify the injecting position of the raw resin, the position of the vent and the like.

Next, the arithmetic unit 31 calculates a resin viscosity based on the pressure data and the like (step S14). Specifically, the arithmetic unit 31 can determine a pressure loss $\Delta P$ by the pressure data detected at two locations spaced in the axial direction of the extrusion and evaluate a resin viscosity from the pressure loss $\Delta P$. Since the resin viscosity is correlated with the temperature and the shear rate, the resin viscosity is preferably calculated based on the pressure data detected under different temperatures and shear rates. This makes it possible to more precisely specify the type of a resin and the properties of the resin.

The arithmetic unit 31 specifies other properties of the resin material by referring to the resin property table 35 using the calculated polymer viscosity as a key (step S15). Specifically, the density, the thermal conductivity and the specific heat when the raw resin is a solid, the density, the thermal conductivity and the specific heat when the raw resin is a melt, the molten heat amount and the melting point are specified.

Next, the arithmetic unit 31 performs initialization using the data acquired and specified by the processing through steps S11 to S15 (step S16).

Specifically, the arithmetic unit 31 initializes the extrusion condition data such as an extruder 1 size, an extrusion output, a screw rotational speed, a cylinder temperature, a tip resin pressure, a raw resin temperature and the like.

The arithmetic unit 31 further initializes the resin physical property data indicating the viscosity of the raw resin injected into the extruder 1, the density, the thermal conductivity and the specific heat in a solid, the density, the thermal conductivity and the specific heat in a melt, the molten heat amount and the melting point.

In addition, the arithmetic unit 31 initializes the screw construction data indicating the constructions of the screw and the cylinder 11.

By performing processing through steps S11 to S16, the information necessary for the arithmetic processing at steps S18 and S22, which will be described later, can be acquired.

If there is data that needs to be initialized but could not be acquired and specified by the processing through steps S11 to S15, the arithmetic unit 31 may acquire the data via the operation panel 20. In addition, if there is data that is necessary for the processing at steps S14 and S15 but could not be acquired and specified by the processing through the steps S11 to S13, the arithmetic unit 31 may acquire the data via the operation panel 20.

The arithmetic unit 31, having completed the processing at step S16, substitutes the variable i with a numerical value indicating the position of a screw tip node 12b (step S17). As illustrated in FIG. 2, the positions in the longitudinal direction of the screw 12 can be denoted by calculation point numbers. Specifically, a calculation point number is assigned to each of partitioned regions formed by partitioning the space inside the cylinder 11 into multiple regions along the axial direction of the extruder. The calculation point number is expressed as a variable i. The value of the variable i increases from a screw root node 12a toward the screw tip node 12b. The screw root node 12a is the node at the root of the screw 12 on the left in FIG. 2 while the screw tip node 12b is the node at the tip of the screw 12 on the right in FIG. 2.

Next, the arithmetic unit 31 calculates the pressure, filling rate and retention time based on the screw characteristic formula and the extrusion condition (step S18).

The screw characteristic formula is expressed by formula (1) below.

$$\Delta P = \frac{(\alpha - \bar{Q})}{\beta} \bar{L} \eta N \qquad (1)$$

where

$$\bar{Q} = \frac{Q}{ND^3} \, , \, \bar{L} = \frac{L}{D}$$

$\Delta P$ : pressure loss in length L of screw
Q: volume flow rate ( extrusion output / density )
$\alpha$ : screw characteristic parameter ( coefficient of pulling fluid of screw )
$\beta$ : screw characteristic parameter ( coefficient of pressure fluid of screw )
L : length of screw
$\eta$ : viscosity of resin material
N : screw rotational speed
D : cylinder diameter

The pressure loss $\Delta P$ and the known tip resin pressure P0 are used to calculate the pressure P at the location denoted by the variable i. The arithmetic unit 31 can sequentially calculate the pressure loss $\Delta P$ from downstream to upstream (step S19 and step S20) to thereby evaluate the pressure in each of the partitioned regions.

The filling rate is expressed by formula (2) below.

$$Fill = \bar{Q} \, / \, \alpha \qquad (2)$$

where

Fill : filling rate
$\alpha$ : screw characteristic parameter

The retention time is expressed by formula (3) below.

$$t = V \times Fill \, / \, Q \qquad (3)$$

where

t : retention time
V : volumetric capacity of channel
Fill : filling rate

The arithmetic unit 31 then determines whether or not the variable i is the value representing the screw root node 12a (step S19). If determining that the variable i is not the value representing the screw root node 12a (step S19: NO), the arithmetic unit 31 decrements the variable i by one (step S20) and returns the processing to step S18.

If determining that the variable i is the value representing the screw root node 12a (step S19: YES), the arithmetic unit 31 substitutes the variable i with the numerical value representing the position of the screw root node 12a (step S21). Note that the processing at step S21 is not necessarily be performed.

Next, the arithmetic unit 31 uses an energy balance formula to calculate the resin temperature, solid phase rate, motive power, torque, ESP, dispersion, distribution and the like (step S22).

The energy balance formula is expressed by formula (4) below. Note that the contact area between the resin material and the cylinder 11 is obtained by multiplying the area of the cylinder 11 at the partitioned region by the filling rate.

$$Q \cdot \rho \cdot Cp \cdot T_{out} - Q \cdot \rho \cdot Cp \cdot T_{in} = h \cdot T \cdot A - h \cdot Tb \cdot A + Ev \qquad (4)$$

where

Q: volume flow rate ( extrusion output / density )
$\rho$: density of resin material
Cp: specific heat of resin material
Tb: cylinder temperature
T: resin temperature
A: contact area between resin material and cylinder
h: coefficient of heat transfer
Ev: viscous heat amount
$T_{out}$ : temperature of resin material flowing from partitioned region
$T_{in}$ : temperature of resin material flowing into partitioned region

The aforementioned formula is modified to obtain the following formula (5). The temperature of the raw resin evaluated one step before can be used for the resin temperature T of the first term in the right side.

$$\Delta T = T_{out} - T_{in} = (h \cdot T \cdot A - h \cdot Tb \cdot A + Ev)/Q/\rho/Cp \qquad (5)$$

By substituting the temperature difference $\Delta T$ evaluated by formula (5) above into formula (6) below, the resin temperature at the current step can be obtained.

$$T_n = T_{n-1} + \Delta T \qquad (6)$$

$T_n$ : resin temperature at n-th step
$T_{n-1}$: resin temperature at (n-1)th step

The arithmetic unit 31, having completed the processing at step S22, determines whether the variable i is the value representing the screw tip node 12b (step S23). If determining that the variable i is not the value representing the screw tip node 12b (step S23: NO), the arithmetic unit 31 increments the variable i by one (step S24) and returns the processing to step S22.

If determining that the variable i is a value representing the screw tip node 12b (step S23: YES), the arithmetic unit 31 determines whether or not the simulation result has converged (step S25). If determining that the simulation result has not converged (step S25: NO), the arithmetic unit 31 returns the processing to step S17 to repeatedly perform the processing through steps S17 to S25.

If determining that the simulation result has converged (step S25: YES), the arithmetic unit 31 displays the analysis result on the display unit 34 (step S26) and ends the processing.

FIG. 8 is a schematic view illustrating a display example of a simulation result according to Embodiment 1. The horizontal axis of the graph depicted in FIG. 8 represents the variable i, that is, the position of the screw 12 in the longitudinal direction. The vertical axes of the multiple graphs in FIG. 8 represents the retention time, the filling rate, the torque, the solid phase rate, the temperature, and the pressure. The arithmetic unit 31 outputs data indicating the distributions of the retention time, filling rate, torque and solid phase rate of the raw resin in the axial direction of the extruder, temperature of the raw resin or the resin pressure, and displays the image displaying the distributions on the display panel 20a as illustrated in FIG. 8.

The simulation device 3 thus configured can automatically set the analysis conditions necessary for simulation and reduce the trouble of manually inputting the analysis conditions.

Specifically, the simulation device 3 is configured to acquire and initialize the set data from the control device 2 of the extruder 1, which makes it possible to reduce the trouble of inputting the extrusion condition data to the simulation device 3.

In addition, the simulation device 3 is configured to acquire temperature data and pressure data from the temperature sensor 15 and the pressure sensor 16 that are installed in the extruder 1, and specify and initialize the properties of the resin, which makes it possible to reduce a trouble of inputting the resin physical property data to the simulation device 3.

More specifically, the simulation device 3 specifies a viscosity of the raw resin and refers to the resin property table 35 using the specified viscosity as a key to thereby specify various properties of the raw resin. This reduces a trouble of inputting data such as the viscosity of the raw resin, the density, the thermal conductivity and the specific heat when the raw resin is a solid, the density, the thermal conductivity and the specific heat when the raw resin is a melt, the molten heat amount and the melting point.

Furthermore, the simulation device 3 is configured to acquire and analyze the screw image and the cylinder image from the imaging device 4 to thereby initialize the screw construction data, which reduces a trouble of inputting the screw construction data to the simulation device 3.

In addition, the arithmetic unit 31 can output data indicating the distributions of the retention time, filling rate, torque, solid phase rate of the raw resin, temperature of the raw resin or the resin pressure in the axial direction of the extruder and display the image displaying the distributions.

While in the present embodiment, the extruder 1 is illustrated as an example of the simulation device 3, the invention may be applied to an injection molding machine and other industrial machines.

While the Flow Analysis Network (FAN) method is employed as an example of a simulation method, other simulation methods such as a finite element method, a finite deposition method, a particle method or the like may be employed to simulate the behavior of the extruder 1 and other industrial machines.

While an example where set data, measurement data and image data are acquired from the control device 2 and the imaging device 4 was described, any of the data may be acquired and used for initialization of the simulation device 3. This reduces a part of the analysis conditions that need manual initialization and reduces the trouble of inputting the analysis conditions.

Embodiment 2

The extruder system according to Embodiment 2 is different from Embodiment 1 in that the control device 2 functions as the simulation device 3 and executes simulation in real time while controlling the operation of the extruder 1 and displays the analysis result. Since the other configurations are similar to those of the simulation device 3 of Embodiment 1, corresponding parts are designated by similar reference codes and detailed description thereof will not be repeated.

The storage unit 22 of the control device 2 according to Embodiment 2 stores the simulation program 32a, the resin property table 35, the first learning model 36 and the second learning model 37 that are stored in the storage unit 32 of the simulation device 3 according to Embodiment 1. The control unit 21 executes the simulation program 32a to perform the processing similar to that of the simulation device 3 according to Embodiment 1. Furthermore, the communication unit 25 of the control device 2 acquires image data from the imaging device 4.

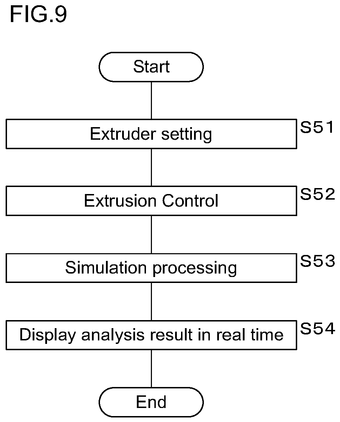

FIG. 9 is a flowchart depicting a processing procedure of the control device 2 according to Embodiment 2. The control unit 21 of the control device 2 accepts data indicating the operating conditions of the extruder 1 via the operation unit 20b and sets the accepted operating conditions (step S51). The operating conditions, which are similar to those in Embodiment 1, include an extruder size, an extrusion output, a screw rotational speed, a cylinder temperature and the like.

Next, the control unit 21 controls the operation of the extruder 1 according to the set operating conditions (step S52). The control unit 21 then executes the simulation processing described in Embodiment 1 while controlling the extruder 1 (step S53). The simulation procedure is similar to that in Embodiment 1. Note that the control unit 21 acquires the set data by reading it from the storage unit 22 and acquires the temperature and pressure data from the signal input unit 24. The control unit 21 then displays the analysis result on the display panel 20a in real time (step S54).

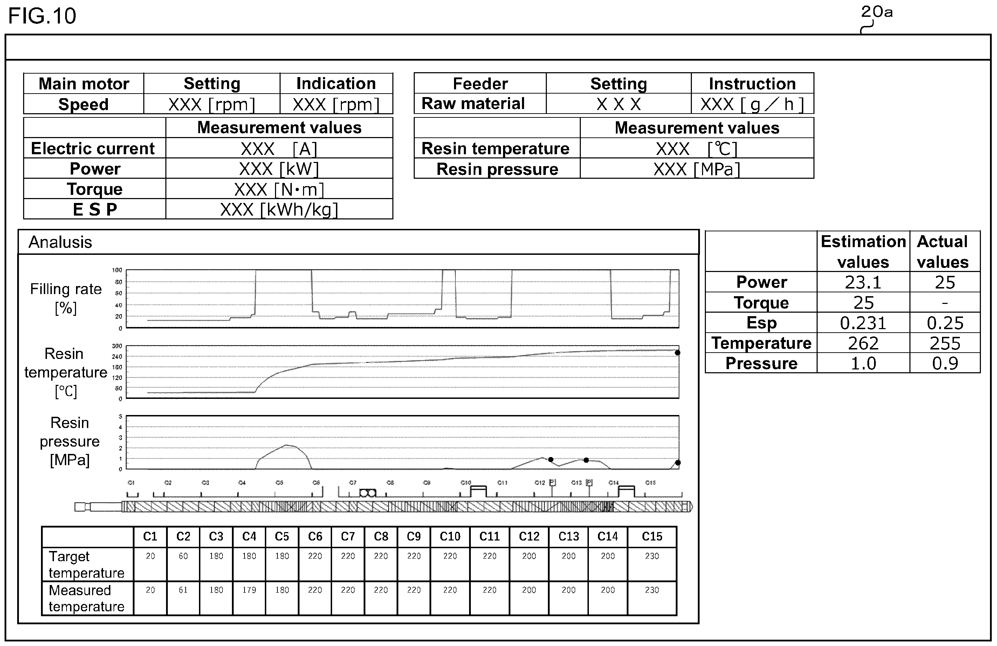

FIG. 10 is a schematic view illustrating a display example of a simulation result according to Embodiment 2. The control unit 21 displays the analysis result on the display panel 20a as in the arithmetic unit 31 of the simulation device 3. For example, the control unit 21 displays graphs depicting the distributions of the filling rate, resin temperature and resin pressure in the axial direction of the extruder. Note that the control unit 21 may be configured so that the actual values of the temperature and pressure measured by the temperature sensor 15 and the pressure sensor 16 are superimposed on the graphs of the resin temperature and the resin pressure as an analysis result.

Moreover, the control unit 21 may display, on the display panel 20a, the data of the operating conditions set in the control device 2 and the measurement values measured by the temperature sensor 15 and the pressure sensor 16 as well.

In addition, the control unit 21 may display, on the display panel 20a, a table in which the measurement values are compared with the estimation values as an analysis result obtained by the simulation processing.

According to Embodiment 2, data indicating the distributions of the retention time, filling rate, torque and solid phase rate of the raw resin, temperature of the raw resin or the resin pressure can be displayed in real time on the operation panel 20 of the extruder 1.

Reference Signs List

1    extruder
2    control device
3    simulation device

| | |
|---|---|
| 4 | imaging device |
| 11 | cylinder |
| 11a | hopper |
| 12 | screw |
| 12a | screw root node |
| 12b | screw tip node |
| 13 | rotary motor |
| 14 | feeder |
| 15 | temperature sensor |
| 16 | pressure sensor |
| 20 | operation panel |
| 20a | display panel |
| 20b | operation unit |
| 21 | control unit |
| 22 | storage unit |
| 23 | control signal output unit |
| 24 | signal input unit |
| 25 | communication unit |
| 30 | recording medium |
| 31 | arithmetic unit |
| 32 | storage unit |
| 33 | communication unit |
| 15 | display unit |
| 32a | simulation program |
| 35 | resin property table |
| 36 | first learning model |
| 37 | second learning model |

**Claims**

1. A simulation device simulating a behavior of an industrial machine, comprising:

   an acquisition unit that acquires data related to a behavior of the industrial machine from a control device performing operation control of the industrial machine, a sensor provided on the industrial machine or an imaging device imaging a component constituting the industrial machine; and
   an arithmetic unit that calculates a physical property indicating a behavior of the industrial machine on the basis of acquired data.

2. The simulation device according claim 1, wherein

   the industrial machine is an extruder having a screw for melting and plasticizing a raw material and a cylinder into which the screw is rotatably inserted,
   the acquisition unit acquires set data indicating an extrusion output of the raw material, a screw rotational speed or a cylinder temperature from the control device, and
   the arithmetic unit calculates the physical quantity using the set data acquired.

3. The simulation device according claim 1, wherein

   the industrial machine is an extruder having a screw for melting and plasticizing a raw material and a cylinder into which the screw is rotatably inserted,
   the sensor provided in the industrial machine includes a temperature sensor detecting a temperature of the cylinder and a pressure sensor detecting pressure inside the cylinder,
   the acquisition unit acquires temperature data or pressure data from the temperature sensor or the pressure sensor, respectively, and
   the arithmetic unit calculates the physical quantity using the temperature data or the pressure data acquired.

4. The simulation device according claim 3, wherein

the pressure sensor is provided at each of multiple locations of the cylinder,
the simulation device further comprises a table in which viscosity of the raw material and a different property of the raw material are associated with each other,
the arithmetic unit
calculates viscosity of the raw material based on pressure data acquired from a plurality of the pressure sensors,
specifies the different property of the raw material using calculated viscosity with reference to the table, and
calculates the physical property using the viscosity and the different property of the raw material.

5. The simulation device according claim 1, wherein

the industrial machine is an extruder having a screw for melting and plasticizing a raw material and a cylinder into which the screw is rotatably inserted,
the acquisition unit acquires image data obtained by imaging the screw from the imaging device, and
the arithmetic unit
specifies a construction of the screw based on acquired image data, and
calculates the physical quantity using data indicating the construction of the screw specified.

6. The simulation device according claim 1, wherein

the industrial machine is an extruder having a screw for melting and plasticizing a raw material and a cylinder into which the screw is rotatably inserted,
the sensor includes a temperature sensor for detecting a temperature of the cylinder and a plurality of pressure sensors for detecting pressures inside the cylinder at a plurality of locations,
the simulation device further comprises a table in which a viscosity of the raw material and other properties of the raw material are associated with each other,
the acquisition unit acquires data indicating an extrusion output of the raw material or a screw rotational speed from the control device, temperature data and pressure data from the temperature sensor and the plurality of pressure sensors, and image data obtained by imaging the screw from the imaging device,
the arithmetic unit
calculates a viscosity of the raw material based on pressure data acquired from the plurality of pressure sensors,
specifies a different property of the raw material using calculated viscosity with reference to the table,
specifies a construction of the screw based on acquired image data, and
calculates the physical quantity using acquired data indicating an extrusion output and a screw rotational speed, pressure data, temperature data, viscosity and a different property of the raw material and data representing a construction of the screw.

7. The simulation device according to any one of claims 1 to 6, wherein the arithmetic unit calculates the physical quantity in parallel with an operation of the industrial machine.

8. A simulation method simulating a behavior of an industrial machine, comprising:

acquiring data related to a behavior of the industrial machine from a control device performing operation control of the industrial machine, a sensor provided on the industrial machine or an imaging device imaging a component constituting the industrial machine; and
calculating a physical property indicating a behavior of the industrial machine on the basis of acquired data.

9. A simulation program causing a computer to simulate a behavior of an industrial machine, the program causing the computer to execute the processing of:

acquiring data related to a behavior of the industrial machine from a control device performing operation control of the industrial machine, a sensor provided on the industrial machine or an imaging device imaging a component constituting the industrial machine; and
calculating a physical property indicating a behavior of the industrial machine on the basis of acquired data.

FIG. 1

Control Device 2

20

3

Data Transfer

12

4

14

11a 1 11 16 16 15

13

EP 4 501 582 A1

FIG.2

FIG.3

FIG.4

FIG.5A

First Learning Model — 36

Screw image data → Piece Detection Model (36a) → Piece Recognition Model (36b) → Type, width (dimension ratio), lead angle and numbers of threads of each screw piece

FIG.5B

Second Learning Model — 37

Cylinder image data → Cylinder Part Detection Model (37a) → Cylinder Part Recognition Model (37b) → Type of each cylinder part

FIG.6

```
                              ┌─────────────┐
                              │    Start    │
                              └──────┬──────┘
                                     │                              S11
┌────────────────────────────────────────────────────────────────────────┐
│                            Acquire data                                  │
│                                                                          │
│  ┌─────────────────────────┐ ┌─────────────────────┐ ┌────────────────┐ │
│  │·Set data                │ │·Measurement data    │ │·Image data     │ │
│  │ Extruder size data      │ │ Temperature data    │ │ Screw image data│ │
│  │ Extrusion output data   │ │ Pressure data       │ │ Cylinder image data│
│  │ Screw rotational speed data│ │                  │ │                │ │
│  │ Cylinder temperature data│ │                    │ │                │ │
│  └─────────────────────────┘ └─────────────────────┘ └────────────────┘ │
└────────────────────────────────────────────────────────────────────────┘
```

Acquire data

·Set data
Extruder size data
Extrusion output data
Screw rotational speed data
Cylinder temperature data

·Measurement data
Temperature data
Pressure data

·Image data
Screw image data
Cylinder image data

S12 Specify screw construction based on screw image data

S13 Specify construction of cylinder based on cylinder image data

S14 Calculate resin viscosity based on pressure data and the like

S15 Specify other properties of resin material

S16 Initialization

·Extrusion condition data
Extruder size, extrusion output, screw rotational speed, cylinder temperature, tip resin pressure, raw resin temperature

·Resin physical property data
Resin viscosity, density in solid and melt, thermal conductivity and specific heat in solid and melt, molten heat amount and melting point

·Screw construction data
Construction of screw
Construction of cylinder

( 1 )

17

## FIG.7

```
                            ( 2 )
                              │
                              ▼ ◄──────────────────────────┐
         ┌──────────────────────────────────┐ S17          │
         │      Variable i = screw tip node  │              │
         └──────────────────────────────────┘              │
                              │                             │
           ┌──────────────────▼──────────────────┐ S18     │
           │     Calculate pressure, filling rate │         │
           │         and retention time based on  │         │
           │         screw characteristic formula │         │
           │           and extrusion condition    │         │
           └──────────────────┬──────────────────┘         │
                              │         S19                 │
              NO      ◇  i = screw root node?  ◇            │
          ┌───────────◇                        ◇            │
          │            ◇                      ◇             │
          │              ◇                  ◇               │
          │                  YES                            │
    ┌─────▼─────┐ S20          │                            │
    │  i ← i−1  │              │                            │
    └───────────┘   ┌──────────▼──────────────┐ S21        │
          │         │     i = screw root node  │            │
          └────────►└─────────────────────────┘            │
                              │                             │
           ┌──────────────────▼──────────────────┐ S22     │
    ┌─────►│      Calculate resin temperature     │         │
    │      │          and solid phase rate        │         │
    │      │         by energy balance formula    │         │
    │      └──────────────────┬──────────────────┘         │
    │                         │        S23                 │
    │          NO      ◇  Variable i = screw tip node?  ◇  │
    │      ┌───────────◇                               ◇   │
    │      │            ◇                             ◇    │
    │ ┌────▼────┐ S24     ◇            YES           ◇     │
    │ │ i ← i+1 │          │                               │
    │ └─────────┘          │       S25                     │
    └──────────┘      ◇  Converged?  ◇    NO               │
                      ◇               ◇ ─────────────────►─┘
                          │ YES
           ┌──────────────▼───────────────────────┐ S26
           │  Display analysis result (retention   │
           │  time of raw resin, filling rate,     │
           │  torque, solid phase rate,            │
           │  temperature of raw resin,            │
           │  resin pressure, and the like)        │
           └──────────────┬───────────────────────┘
                          │
                     (  End  )
```

FIG.8

34

Retention time

Filling rate

Torque

Solid phase rate

Temperature

Pressure

FIG.9

```
                    ┌──────────────┐
                    │    Start      │
                    └──────┬───────┘
                           │
        ┌──────────────────┴──────────────────┐ S51
        │          Extruder setting           │
        └──────────────────┬──────────────────┘
                           │
        ┌──────────────────┴──────────────────┐ S52
        │         Extrusion Control           │
        └──────────────────┬──────────────────┘
                           │
        ┌──────────────────┴──────────────────┐ S53
        │        Simulation processing        │
        └──────────────────┬──────────────────┘
                           │
        ┌──────────────────┴──────────────────┐ S54
        │   Display analysis result in real time   │
        └──────────────────┬──────────────────┘
                           │
                    ┌──────┴───────┐
                    │     End       │
                    └──────────────┘
```

FIG.10

20a

| Main motor | Setting | Indication |
|---|---|---|
| **Speed** | XXX [rpm] | XXX [rpm] |
| | **Measurement values** | |
| **Electric current** | XXX [A] | |
| **Power** | XXX [kW] | |
| **Torque** | XXX [N·m] | |
| **E S P** | XXX [kWh/kg] | |

| Feeder | Setting | Instruction |
|---|---|---|
| **Raw material** | X X X | XXX [g／h] |
| | **Measurement values** | |
| **Resin temperature** | XXX [℃] | |
| **Resin pressure** | XXX [MPa] | |

| | Estimation values | Actual values |
|---|---|---|
| **Power** | 23.1 | 25 |
| **Torque** | 25 | - |
| **Esp** | 0.231 | 0.25 |
| **Temperature** | 262 | 255 |
| **Pressure** | 1.0 | 0.9 |

Analusis

Filling rate [%]

Resin temperature [℃]

Resin pressure [MPa]

| | C1 | C2 | C3 | C4 | C5 | C6 | C7 | C8 | C9 | C10 | C11 | C12 | C13 | C14 | C15 |
|---|---|---|---|---|---|---|---|---|---|---|---|---|---|---|---|
| Target temperature | 20 | 60 | 180 | 180 | 180 | 220 | 220 | 220 | 220 | 220 | 220 | 200 | 200 | 200 | 230 |
| Measured temperature | 20 | 61 | 180 | 179 | 180 | 220 | 220 | 220 | 220 | 220 | 220 | 200 | 200 | 200 | 230 |

EP 4 501 582 A1

## INTERNATIONAL SEARCH REPORT

| International application No. |
|---|
| **PCT/JP2022/040054** |

### A. CLASSIFICATION OF SUBJECT MATTER

***B29C 48/395***(2019.01)i; ***B29C 48/505***(2019.01)i; ***B29C 48/68***(2019.01)i; ***B29C 48/92***(2019.01)i
FI:   B29C48/92; B29C48/395; B29C48/505; B29C48/68

According to International Patent Classification (IPC) or to both national classification and IPC

### B. FIELDS SEARCHED

Minimum documentation searched (classification system followed by classification symbols)
    B29C48/395; B29C48/505; B29C48/68; B29C48/92

Documentation searched other than minimum documentation to the extent that such documents are included in the fields searched

    Published examined utility model applications of Japan 1922-1996
    Published unexamined utility model applications of Japan 1971-2022
    Registered utility model specifications of Japan 1996-2022
    Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2017-217786 A (DOSHISHA) 14 December 2017 (2017-12-14) claims 1-3, paragraphs [0016], [0019], [0023], [0042], [0043], [0054], fig. 1 | 1, 7-9 |
| A | entire text, all drawings | 2-6 |
| Y | JP 2011-173276 A (THE JAPAN STEEL WORKS LTD.) 08 September 2011 (2011-09-08) paragraphs [0017]-[0019] | 1-4, 7-9 |
| A | entire text, all drawings | 5-6 |
| Y | JP 2006-103316 A (TOYO SEIKI SEISAKUSHO KK) 20 April 2006 (2006-04-20) paragraphs [0028]-[0044] | 1-4, 7-9 |
| A | entire text, all drawings | 5-6 |
| A | JP 2016-083829 A (RESEARCH LABORATORY OF PLASTICS TECHNOLOGY CO., LTD.) 19 May 2016 (2016-05-19) entire text, all drawings | 1-9 |
| A | JP 2008-023812 A (ASAHI KASEI ENGINEERING KK) 07 February 2008 (2008-02-07) entire text, all drawings | 1-9 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **16 November 2022** | **29 November 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

INTERNATIONAL SEARCH REPORT
Information on patent family members

International application No.

**PCT/JP2022/040054**

| Patent document cited in search report | | | Publication date (day/month/year) | Patent family member(s) | Publication date (day/month/year) |
|---|---|---|---|---|---|
| JP | 2017-217786 | A | 14 December 2017 | (Family: none) | |
| JP | 2011-173276 | A | 08 September 2011 | (Family: none) | |
| JP | 2006-103316 | A | 20 April 2006 | (Family: none) | |
| JP | 2016-083829 | A | 19 May 2016 | (Family: none) | |
| JP | 2008-023812 | A | 07 February 2008 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004148722 A